# EUROPÄISCHE PATENTANMELDUNG

(11) **EP 1 533 874 A2**
(43) Veröffentlichungstag der Anmeldung: **25.05.2005**
(21) Anmeldenummer: 04027585.1
(22) Anmeldetag: 19.11.2004
(51) Int. Cl.: H01S 5/14

(54) **Laserdioden-Anordnung mit externem Resonator**

(30) Priorität: 19.11.2003 DE 20317904 U
(71) Anmelder: Sacher, Joachim, 35041 Marburg/Lahn (DE)
(72) Erfinder: Sacher, Joachim, 35041 Marburg/Lahn (DE)
(74) Vertreter: Buchhold, Jürgen (DE)

(57) **Zusammenfassung**

Eine Laserdioden-Anordnung (10) zur Erzeugung von einmodiger, durchstimmbarer Laserstrahlung (15) hat eine Laserdiode (11), die eine Rückfacette (16) und eine Frontfacette (17) aufweist und einen ersten Resonator (R1) bildet, sowie einen daran angekoppelten externen Resonator (R2), der wenigstens eine optische Transmissionskomponente (30) und wenigstens ein wellenlängenselektives optisches Reflexionselement (40, 50) aufweist und von der Laserdiode (11) emittiertes Laserlicht (13) in den ersten Resonator (R1) zurückkoppelt. Um die Wellenlänge kontinuierlich und frei von Modensprüngen durchstimmen zu können und um gleichzeitig eine höhere Ausgangsleistung zu erreichen, ist eine Einrichtung (60) zur Variation der Ankopplungsgüte des ersten Resonators (R1) an den externen Resonator (R2) vorgesehen ist. Die Einrichtung (60) ist bevorzugt ein auf der Laserdiode (11) aufgebrachter elektrischer Anschlußkontakt (61), der in voneinander unabhängig ansteuerbare Anschlußsegmente (62, 63) unterteilt ist. Jedes Anschlußsegment (62, 63) ist über eine Regelschaltung (66) mit einem Steuerstrom beaufschlagbar, wobei der der dem ersten Anschlußsegment (62) zugeführte Steuerstrom konstant ist und der dem weiteren Anschlußsegment (63) zugeführte Steuerstrom in Abhängigkeit von der Position der wellenlängenselektiven optischen Reflexionselemente (40, 50) in Bezug zur Laserdiode (11) von der Regelschaltung (66) veränderbar ist.

## Beschreibung

Die Erfindung betrifft eine Laserdioden-Anordnung mit einem externen Resonator gemäß dem Oberbegriff von Anspruch 1.

Durch eine in Flußrichtung betriebene Halbleiter-Laserdiode kann man mittels stimulierter Emission kohärentes Licht erzeugen. Bedingt durch die Güte des zwischen den Endflächen des Halbleiterkristalls gebildeten Resonators und bedingt durch die spontane Emission innerhalb der Laserdiode hat jedoch das emittierte Laserlicht meist eine relativ große Linienbreite. Um diese zu verringern, verwendet man gewöhnlich einen externen Resonator, der über wellenlängenselektive Elemente wie Gitter und Filter nur Licht bestimmter Wellenlängen - den Resonatormoden - in die Laserdiode zurückkoppelt. Dies führt zu einer Verstärkung der stimulierten Emission auf der jeweils ausgewählten Wellenlänge. Gleichzeitig läßt sich über das wellenlängenselektive Element die Emissionswellenlänge über den Verstärkungsbereich der Laserdiode durchstimmen. Zwei typische Laser-Anordnungen mit externen Resonatoren, die wellenlängenselektive Elemente enthalten, sind beispielsweise die Littrow- und die Littman-Anordnung.

Um eine möglichst gute Ankopplung des externen Resonators an den Resonator der Halbleiter-Laserdiode zu erreichen, ist die dem externen Resonator zugewandte Laserfacette der Laserdiode im allgemeinen antireflexionsbeschichtet.

Wird beim Durchstimmen der Emissionswellenlänge in einem externen Resonator die Resonatorlänge konstant gehalten, so ändert sich die Anzahl der Knoten der stehenden Lichtwelle im Resonator, was als Modensprung bezeichnet wird. Eine weitere Ursache hierfür liegt in der nicht verschwindenden Reflektivität der dem externen Resonator zugewandten antireflexionsbeschichteten Laserdiodenfacette. Die Resonanzen der Laserdiode überlagern sich mit denen des externen Resonators, was zur Folge hat, daß die Wellenlänge nicht kontinuierlich veränderbar ist, sondern in diskreten Schritten springt. Ebenso treten Fluktuationen in der Ausgangsleistung der Laserdiode auf, was sich beispielsweise bei spektroskopischen Untersuchungen störend auswirkt.

Als Lösung hierfür hat man vorgeschlagen, beim Abstimmen der Wellenlänge die optische Länge des externen Resonators über mechanische und/oder piezoelektrische Stellglieder zu variieren. Hierbei ist jedoch zu beachten, daß Halbleiter-Laserdioden aufgrund ihres Lichtverstärkungsmechanismus eine erhebliche chromatische Dispersion aufweisen. Dadurch unterscheidet sich die geometrische Länge des externen Resonators von seiner optischen Länge.

DE-U1-296 06 494 offenbart daher eine Abstimmvorrichtung für eine Halbleiter-Laserdiode in Littman-Anordnung mit einem um eine feststehende Achse drehbar gelagerten Abstimmarm, auf dem ein Resonatorendspiegel befestigt ist, und mit einem optischen Beugungsgitter, das winkelveränderlich und in Bezug auf die Drehachse des Abstimmarms abstandsveränderlich angeordnet ist. Zum Ausgleich der chromatischen Dispersion ist für die 1. bis 3. Ordnung jeweils ein Justiermittel vorhanden, die separat voneinander einzustellen sind.

WO-A1-91/03848 beschränkt sich auf die Angabe einer aufwendigen Methode zur Bestimmung des Drehpunktes eines Beugungsgitters, das in einem Resonator in Littrow-Anordnung an einem um eine Achse drehbar bzw. schwenkbar gelagerten Tragarm befestigt ist. Weitere Stell- oder Justagemittel sind nicht vorgesehen, so daß Beiträge zweiter und höherer Ordnung der chromatischen Dispersion nur bedingt kompensiert werden. Ferner bleibt die nicht verschwindende Reflektivität der dem externen Resonator zugewandten Laserdiodenfacette unberücksichtigt, so daß beim Durchstimmen der Wellenlänge weiterhin Leistungsschwankungen und Modensprünge auftreten können.

Ziel der Erfindung ist es, diese und weitere Nachteile des Stand der Technik zu überwinden und eine Laserdioden-Anordnung mit einem externen Resonator zu schaffen, mit der einmodiges Laserlicht erzeugt werden kann, dessen Wellenlänge kontinuierlich und frei von Modensprüngen durchstimmbar ist. Der Aufbau soll mit einfachen Mitteln kostengünstig realisierbar und leicht zu handhaben sein. Ein weiteres Ziel der Erfindung besteht darin, eine deutlich höhere Ausgangsleistung der Laserdioden-Anordnung erreichen zu können sowie eine justageinvariante Ausbildung des externen Resonators zu schaffen.

Hauptmerkmale der Erfindung sind im kennzeichnenden Teil der Ansprüche 1 und 25 angegeben. Ausgestaltungen sind Gegenstand der Ansprüche 2 bis 24 und 26 bis 28.

Bei einer Laserdioden-Anordnung zur Erzeugung von einmodiger, durchstimmbarer Laserstrahlung, mit einer Laserdiode, die eine Rückfacette und eine Frontfacette aufweist und einen ersten Resonator bildet, und mit einem daran angekoppelten externen Resonator, der wenigstens eine optische Transmissionskomponente und wenigstens ein wellenlängenselektives optisches Reflexionselement aufweist und von der Laserdiode emittiertes Laserlicht in den ersten Resonator zurückkoppelt, sieht die Erfindung laut Anspruch 1 vor, daß eine Einrichtung zur Variation der Ankopplungsgüte des ersten Resonators an den externen Resonator vorgesehen ist.

Dadurch ist es möglich, die optische Länge des von der Laserdiode gebildeten ersten Resonators gezielt zu verändern, so daß beide Resonatoren über nahezu den gesamten Wellenlängenbereich stets optimal miteinander gekoppelt sind. Sobald beim Durchstimmen des Lasers in der Ausgangsstrahlung Leistungsschwankungen auftreten oder zu erkennen sind, besteht die Möglichkeit dies durch eine Veränderung der Ankopplungsgüte unmittelbar auszugleichen. Mithin ist es auf einfache Art möglich, einmodige, modensprungfrei durchstimmbare Laserstrahlung zu erzeugen. Aufwendige mechanische Justiermittel am oder im externen Resonator sind nicht erforderlich, was sowohl den Aufbau als auch die Handhabung wesentlich vereinfacht.

Gemäß Anspruch 2 ist die Einrichtung zur Variation der Ankopplungsgüte an oder in dem ersten Resonator ausgebildet, was einen kompakten Aufbau ermöglicht. Dazu trägt auch Anspruch 3 bei, wenn nämlich die Einrichtung zur Variation der Ankopplungsgüte an oder in der Laserdiode ausgebildet ist. Hierzu sieht Anspruch 4 beispielsweise vor, daß die Einrichtung zur Variation der Ankopplungsgüte einen auf der Laserdiode aufgebrachten elektrischen Anschlußkontakt umfaßt, der in voneinander unabhängig ansteuerbare Anschlußsegmente unterteilt ist.

Konstruktiv ist es dabei günstig, wenn der Anschlußkontakt nach Anspruch 5 senkrecht zur Längsachse der Laserdiode unterteilt ist, wobei das der Frontfacette zugewandte erste Anschlußsegment eine Länge aufweist, die größer ist als die Länge des weiteren Anschlußsegments. Über letzteres kann man rasch und präzise die Güte des ersten Resonators verändern, ohne die Hauptfunktion der Laserdiode zu beeinträchtigen.

In der Ausbildung von Anspruch 6 ist jedes Anschlußsegment über eine Regelschaltung mit einem Steuerstrom beaufschlagbar, wobei der dem ersten Anschlußsegment zugeführte Steuerstrom laut Anspruch 7 konstant ist. Der dem weiteren Anschlußsegment zugeführte Steuerstrom läßt sich hingegen gemäß Anspruch 8 in Abhängigkeit von der Position der wellenlängenselektiven optischen Reflexionselemente relativ zur Laserdiode über die Regelschaltung verändern, wodurch das von dem externen Resonator zurückgekoppelte Laserlicht von der Laserdiode im Bereich des zweiten Segments mehr oder weniger verstärkt wird, bevor es in den Hauptbereich der Laserdiode gelangt, der von dem ersten Anschlußsegment definiert wird. Mit der Stromänderung ändert sich die Temperatur in der aktiven Zone der Laserdiode, die dadurch ihre optische Länge ändert. Mithin ist es durch einfache Stromänderung an den Anschlußsegmenten möglich, die Güte des von der Laserdiode gebildeten ersten Resonators gezielt zu verändern, so daß das Zwei-Resonator-System stets optimal aneinander gekoppelt ist.

Die Variation der Güte des ersten Resonators kann laut Anspruch 9 passiv erfolgen, indem der dem weiteren Anschlußsegment zugeführte Steuerstrom und die Position der bzw. des wellenlängenselektiven optischen Reflexionselements in einer über die Regelschaltung vorgebbaren Beziehung zueinander stehen. Wenn also das Reflexionselement, z.B. ein Gitter, eine bestimmte Winkelstellung einnimmt, wird an dem weiteren Ansteuersegment von der Regelschaltung ein entsprechend zugeordneter Strom angelegt. Verändert man die Winkelstellung des Gitters, z.B. beim Durchstimmen des Lasers, wird der Steuerstrom von der Regelschaltung automatisch nachgeführt, so daß eine stets modensprungfreie und leistungskonstante Laserstrahlung ausgekoppelt wird.

Ergänzend oder alternativ kann man den Steuerstrom an dem weiteren Anschlußsegment in Abhängigkeit von der Leistung der aus der Laserdioden-Anordnung ausgekoppelten Laserstrahlung verändern (Anspruch 10). Sobald sich beim Durchstimmen des Lasers die Ausgangsleistung in Bezug auf einen definierten Schwellenwert ändert, greift die Regelschaltung ein und verändert den Steuerstrom an dem weiteren Anschlußelement.

Für eine optimale Auskopplung der Laserstrahlung über das wellenlängenselektive Element ist es günstig, wenn die Rückfacette der Laserdiode nach Anspruch 11 verspiegelt und die dem externen Resonator zugewandte Frontfacette der Laserdiode gemäß Anspruch 12 mit einer Antireflexionsbeschichtung versehen ist, wobei die Reflektivität der Rückfacette in Einklang mit Anspruch 13 bevorzugt kleiner als 0,1 % ist.

Vorteilhaft weist die Laserdiode laut Anspruch 14 eine aktive Zone auf, die eine rechteckige oder trapezförmige Form hat. Letzteres verhindert das Anschwingen von räumlichen Moden, wodurch die Strahlqualität weiter verbessert wird. Überdies trägt auch die Trapezform der aktiven Zone zur Leistungserhöhung bei.

Anspruch 15 sieht überdies vor, daß die optische Transmissionskomponente ein Kollimator ist. Dieser sorgt dafür, daß das aus der Laserdiode austretende divergente Laserlicht als Parallelstrahlbündel auf das wellenlängenselektive Reflexionselement fällt. Letzteres ist laut Anspruch 16 bevorzugt ein optisches Beugungsgitter und/oder gemäß Anspruch 17 ein Spiegel. Dementsprechend bildet die Laserdiode und der externe Resonator nach Anspruch 18 eine Littman- oder eine Littrow-Anordnung.

In der Weiterbildung von Anspruch 19 ist die Laserdiode ein Quantenkaskadenlaser, ein Quantenpunktlaser oder ein Dilute-Nitrid-Arsenid-Laser, was die Nutzung größerer oder anders gelagerter Wellenlängenbereiche eröffnet.

Eine wichtige Maßnahme der Erfindung besteht laut Anspruch 20 darin, daß die Laserstrahlung über die Rückfacette der Laserdiode auskoppelbar ist, wobei das Verhältnis der Reflektivität der Rückfacette zur Reflektivität des optischen Reflexionselements sehr viel kleiner als 1 ist. Dadurch ist es möglich, aus der Laserdioden-Anordnung eine sehr viel höhere Leistung auszukoppeln, wobei zugleich Schwankungen der Lichtleistung und Modensprünge in der spektralen Durchstimmkurve des Lasersystems wirksam vermieden werden. Dazu trägt insbesondere auch Anspruch 21 bei, wenn das Verhältnis der Reflektivität der Rückfacette zur Reflektivität des optischen Reflexionselements kleiner als 0,1 ist. Gemäß Anspruch 22 ist die Reflektivität der Rückfacette bevorzugt kleiner oder gleich 1 % und die Reflektivität des optischen Reflexionselements größer oder gleich 95 %.

Anspruch 23 sieht vor, daß die Laserdiode in Axialrichtung eine Länge aufweist, die größer oder gleich 500 µm ist, was ebenfalls zu einer deutlichen Steigerung der auskoppelbaren Leistung beiträgt. Gleichzeitig verringert sich die Linienbreite der emittierten Laserstrahlung.

In der Ausbildung von Anspruch 24 ist im Bereich der Rückfacette eine optische Transmissionskomponente angeordnet, z.B. eine Kollimationslinse. Diese sorgt dafür, daß das divergent aus der Rückfacette der Laserdiode austretende Laserlicht parallelisiert wird. Man kann aber auch - je nach Verwendung des Laserlichts - eine andere Optik verwenden und/oder dem Kollimator weitere optische Elemente nachschalten.

Eine bedeutsame Weiterbildung der Erfindung geht aus Anspruch 25 hervor, für die selbständiger Schutz beansprucht wird. Danach ist bei einer Laserdioden-Anordnung zur Erzeugung von einmodiger, durchstimmbarer Laserstrahlung, mit einer Laserdiode, die eine Rückfacette und eine Frontfacette aufweist und einen ersten Resonator bildet, und mit einem daran angekoppelten externen Resonator, der wenigstens eine optische Transmissionskomponente und wenigstens ein wellenlängenselektives optisches Reflexionselement aufweist und von der Laserdiode emittiertes Laserlicht in den ersten Resonator zurückkoppelt, erfindungsgemäß vorgesehen, daß der Transmissionskomponente eine Sammellinse und eine zerstreuende Zylinderlinse zugeordnet ist, wobei die Achse der Zylinderlinse im wesentlichen parallel zu den optischen Reflexionselementen angeordnet ist.

Justiert man die Transmissionskomponente derart, daß auf dem bzw. den optischen Reflexionselementen eine punktgenaue Abbildung der Laserfacette erfolgt, so entsteht durch die zerstreuende Zylinderlinse ein Linienfokus. Dadurch wird die Laser-Anordnung justageinvariant gegenüber Verkippungen des bzw. der Reflexionselemente um eine Achse parallel zur Längsachse A der Laserdiode.

Es sind bereits Resonatoren bekannt, die justageinvariant ausgebildet sind. EP-A2-0 347 213 schlägt beispielsweise ein Laserdiodensystem mit externem Resonator in Littrow-Anordnung vor, das neben einer Kollimationsoptik und einem Beugungsgitter einen anamorphotischen Übertragungsbereich aufweist, der den Laserstrahl derart formt, daß er auf dem Beugungsgitter einen Linienfokus bildet. Hierzu ist hinter der Kollimationslinse eine zylindrische Sammellinse angeordnet, deren optische Achse senkrecht zu den Gitterlinien des Resonatorgitters liegt. Zusätzliche Prismen dienen als Strahlaufweiter, um die Breite des Laserstrahls weiter zu erhöhen.

Eine solche Vorrichtung leidet jedoch unter der Vielzahl der optischen Bauelemente und der hieraus resultierenden Baugröße. Eine Miniaturisierung dieser Vorrichtung erscheint aufgrund der Qualitätsprobleme bei der Herstellung kurzbrennweitiger Zylinderlinsen nur schwer möglich.

Die erfindungsgemäße Optik hingegen überwindet derartige Nachteile. Sie läßt sich äußerst kompakt und robust ausbilden, wodurch die gesamte Laseranordnung selbst mechanischen Stößen und Vibrationen problemlos standhält. Selbst der Einsatz in meist rauhen industriellen Umgebungen oder im Weltraum ist möglich. Das von dem wellenlängenselektiven Element rückgekoppelte Licht wird stets exakt auf die lichtemittierende Laserfacette fokussiert, so daß auch auf Dauer weder Modensprünge noch Leistungsverluste auftreten. Aufwendige Ausgleichsmechaniken sind nicht erforderlich.

Verschiedene Varianten gehen aus den Ansprüchen 26 und 27 hervor, wonach die Zylinderlinse zwischen der Laserdiode und der Sammellinse angeordnet ist. Oder man setzt die Sammellinse zwischen die Laserdiode und die Zylinderlinse.

Eine weitere Ausführungsform der Erfindung sieht vor, daß das optische Reflexionselement von zwei Teilgittern gebildet wird, die in einem Winkel von 90° zueinander angeordnet sind. Auch hierdurch wird die Laser-Anordnung justageinvariant gegenüber Verkippungen der ein Hutgitter bildenden Teilgitter senkrecht zu den Gitterlinien.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Es zeigen:
- Fig. 1: eine schematische Darstellung einer Laserdioden-Anordnung in Littman-Anordnung,
- Fig. 2: eine schematische Darstellung einer Laserdioden-Anordnung in Littrow-Anordnung,
- Fig. 3: eine schematische Darstellung eines Hutgitters für eine Laserdioden-Anordnung in Littrow-Anordnung und
- Fig. 4: das Hutgitter von Fig. 3 in einer Draufsicht.

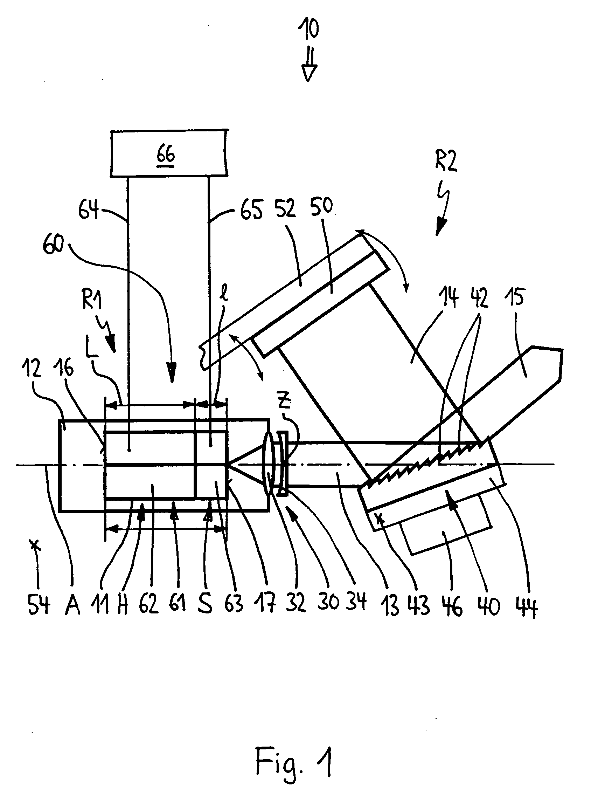

Die in Fig. 1 allgemein mit 10 bezeichnete Laserdioden-Anordnung zur Erzeugung von einmodiger, durchstimmbarer Laserstrahlung 15 ist als Littman-Anordnung ausgebildet.

Sie umfaßt eine Halbleiterlaserdiode 11, die auf einem Träger 12, z.B. einer Grundplatte oder einem Montageblock, befestigt ist. Die Rückfacette 16 der Laserdiode 11 ist mit einer Verspiegelung versehen, deren Reflektivität vorzugsweise nahe 100 % liegt. Die Frontfacette 17 hingegen ist mit einer Antireflexionsbeschichtung versehen, deren Reflektivität kleiner als 0,1 % beträgt. Beide Facetten 16, 17 bilden die Endflächen eines ersten Resonators R1, dessen Länge von der Länge D des Halbleiterkristalls der Laserdiode 11 bestimmt wird.

Das von der Laserfacette 17 emittierte Laserlicht 13 wird von einer optischen Transmissionskomponente 30 in Form einer rotationssymmetrischen Sammellinse 32 auf die Oberfläche eines optischen Beugungsgitters 40 fokussiert, das als wellenlängenselektives Reflexionselement zusammen mit einem Spiegel 50 Bestandteil eines externen Resonators R2 ist. Die Reflektivität des planen Gitters 40 beträgt vorzugsweise etwa 5 %, so daß ein Großteil des Laserlichts nullter Ordnung als Nutzstrahl 15 ausgekoppelt wird. Licht 14 der ersten Beugungsordnung hingegen wird von dem Gitter 40 auf den Spiegel 50 gelenkt, von diesem reflektiert und - nachdem es von dem Gitter 40 ein zweites Mal gebeugt wurde - in die Laserdiode 11 zurückgekoppelt.

Das Gitter 40 ist bevorzugt auf einem Träger 44 montiert, der mittels Justier- bzw. Stellmitteln 46, z.B. einem Verschiebetisch, um wenigstens eine Achse 43 parallel zu den Gitterlinien 42 verschwenkt und/oder in verschiedenen Raumrichtungen linear verschoben werden kann. Die Gitterlinien 42 des Gitters 40 verlaufen senkrecht zur Längsachse A der Laserdiode 11.

Der Spiegel 50 ist auf einem Tragarm 52 befestigt, der um eine Achse 54 schwenkbar gelagert ist. Letztere verläuft parallel zur Spiegelebene. Wird der Tragarm 52 um die Achse 54 verschwenkt, ändert sich die von dem Gitter 40 in die Laserdiode 11 zurückgekoppelte Wellenlänge. Der Laser 10 wird verstimmt. Gleichzeitig ändert sich die durch die Länge des externen Resonators R2 bestimmte Wellenlänge, was jedoch durch eine entsprechende Verschiebung des Gitters 40 relativ zum Spiegel 50 bzw. relativ zu dessen Drehachse 54 unter Einbeziehung mehrerer Dispersionsordnungen ausgeglichen werden kann.

Hinter der Sammellinse 32 ist im Strahlengang des emittierten Laserlichts 13 eine zerstreuende Zylinderlinse 34 angeordnet, deren Achse Z parallel zu den Gitterlinien 42 des Gitters 40 verläuft. Position und Fokus der Zylinderlinse 34 sind so gewählt, daß auf dem Gitter 40 ein Linienfokus entsteht, d.h. das von der Laserfacette 17 emittierte Laserlicht 13 wird von der Transmissionskomponente 30 als (nicht gezeigte) schmale Linie auf dem Gitter 40 abgebildet, wobei die Höhe der Linie sehr viel kleiner ist als deren Breite. Letztere bestimmt die Selektivität des Gitters 40.

Durch diese Anordnung und Fokussierung wird der Laser 10 insgesamt justageinvariant gegenüber Verkippungen des Gitters 40 um eine Achse senkrecht zu den Gitterlinien 42, die beispielsweise beim Verschwenken des Gitters 40 um die Achse 43 oder durch Erschütterungen entstehen können. Überdies treten keine durch die Resonatoroptik 30, 40, 50 bedingten Leistungsverluste auf, weil die Abbildungseigenschaften des äußerst kompakt realisierbaren Resonators R2 stets optimal sind. Folglich bleibt das Abstimmverhalten der Laser-Anordnung 10 beim Verschwenken des Gitters 40 um die Achse 43 voll erhalten. Die Leistungsausbeute ist sehr hoch.

Beim Durchstimmen der Wellenlänge über den Spiegel 50 zeigt sich trotz Nachführung des Gitters 40 die nicht verschwindende Reflektivität der dem externen Resonator R2 zugewandten Frontfacette 17 der Laserdiode 11 in Form von Leistungsschwankungen sowie in Form von Veränderungen der Resonatorgüte, was gewöhnlich zu Modensprüngen führt.

Um dem zu begegnen, ist der von der Laserdiode 11 gebildete erste Resonator R1 mit einer Einrichtung 60 versehen, mit der man die Ankopplungsgüte des ersten Resonators R1 an den externen Resonator R2 gezielt variieren kann. Die Einrichtung 60 umfaßt im wesentlichen einen auf der Laserdiode 11 aufgebrachten elektrischen Anschlußkontakt 61, der senkrecht zur Längsachse A in zwei separate Anschlußsegmente 62, 63 unterteilt ist, sowie eine Regelschaltung 66. Jedes Anschlußsegment 62, 63 ist über eine Anschlußleitung 64, 65 an die Regelschaltung 66 angeschlossen. Mit dieser kann man die Anschlußsegmente 62, 63 unabhängig voneinander mit einem Steuer- bzw. Segmentstrom beaufschlagen. Man erkennt in Fig. 1, daß das der Rückfacette 16 zugewandte erste Anschlußsegment 62 eine Länge L aufweist, die größer ist als die Länge I des weiteren Anschlußsegments 63 und daß die Gesamtlänge L + I der Anschlußsegmente 62, 63 bis auf eine schmale (nicht dargestellte) Lücke der Länge D der Laserdiode 11 entspricht. Letztere wird mithin durch die Anschlußsegmente 62, 63 in ein größeres Hauptsegment H und ein vorgelagertes kleineres Steuersegment S unterteilt.

Hält man beispielsweise den Segmentstrom an dem ersten Anschlußsegment 62 konstant, so kann man durch eine Änderung des dem zweiten Anschlußsegment 63 zugeführten Segmentstroms das von dem externen Resonator R2 zurückgekoppelte Laserlicht in dem Steuersegment S mehr oder weniger verstärken, bevor es in das Hauptsegment H der Laserdiode 11 gelangt. Die Stromänderung am zweiten Anschlußsegment 63 führt zu einer Temperaturänderung im Steuersegment S und damit zu einer Temperaturänderung in der aktiven Zone der Laserdiode 11. Dadurch ändert sich die optische Länge der Laserdiode 11 bzw. des Resonators R1, der mithin stets optimal an den externen Resonator R2 angekoppelt ist.

Durch die separat steuerbaren Ströme an den Anschlußsegmenten 62, 63 wird zudem eine gezielte Variation des Aufnahmevermögens des ersten Resonators R1 für das von dem externen Resonator R2 zurückgekoppelte Laserlicht erreicht, was zu einer deutlichen Steigerung der Laserlichtausbeute führt. Beispielsweise kann man bei einer sich verschlechternden Ankopplung die Stromzuführung am zweiten Anschlußsegment 63 erhöhen. Verbessert sich die Ankopplung wird der Segmentstrom beim weiteren Durchstimmen der Wellenlänge wieder verringert.

Die Regelung der Segmentströme an den Anschlußsegmenten 62, 63 übernimmt die Regelschaltung 66, die hierzu mit einer (nicht dargestellten) elektronischen Steuerung versehen ist. Bei einer passiven Anpassung der Ankopplungsgüte wird der dem zweiten Anschlußsegment 63 zugeführte Steuerstrom in Abhängigkeit von der Position des Gitters 40 und/oder des Spiegels 50 relativ zur Laserdiode 11 bzw. zum Resonator R1 verändert, wobei die Stromstärke und die Position des Gitters 40 bzw. des Spiegels 50 in einer über die Regelschaltung 66 vorgebbaren Beziehung zueinander stehen. Dadurch ist sichergestellt, daß beim Durchstimmen des Lasers 10 die Ankopplungsgüte stets korrekt nachgeführt wird.

Um die Anpassung der Ankopplungsgüte zu automatisieren, wird während dem Durchstimmen der Wellenlänge die Leistung der ausgekoppelten Laserstrahlung 15 gemessen und der dem zweiten Anschlußsegment 63 zugeführte Strom in Abhängigkeit von der erfaßten Leistung und je nach Winkelstellung des Gitters 40 und/oder des Spiegels 50 nachgeführt. Die Laserdioden-Anordnung 10 emittiert damit stets eine einmodige Laserstrahlung 15, die frei von Modensprüngen durchstimmbar ist. Aufwendige mathematische Berechnungen zur Festlegung der Drehachse 54 für den Spiegel oder eine Aufwendige Nachführung des Gitters 40 ist nicht mehr erforderlich. Die gesamte Anordnung 10 läßt sich äußerst kompakt und kostengünstig realisieren und ebenso einfach handhaben.

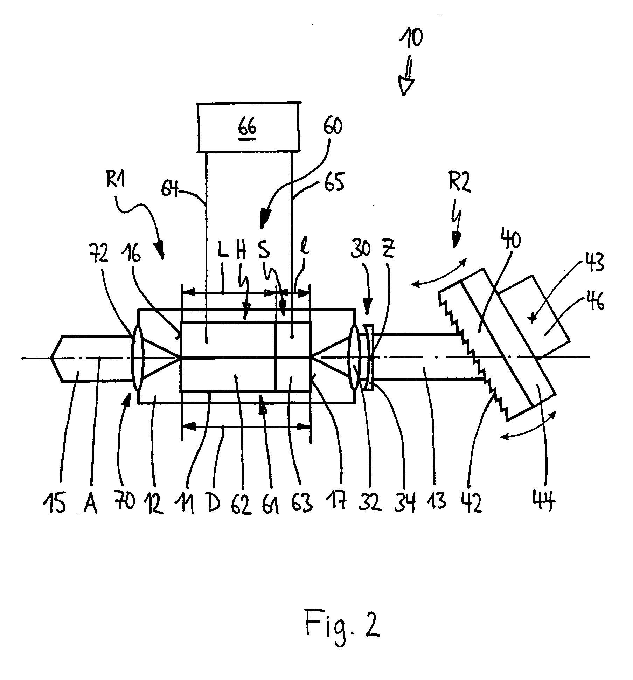

In der Ausführungsform von Fig. 2 bildet die Laserdioden-Anordnung 10 eine Littrow-Anordnung. Diese besteht im wesentlichen aus der Laserdiode 11 und dem externen Resonator R2, der von der optischen Transmissionskomponente 30, bestehend aus Sammellinse 32 und zerstreuender Zylinderlinse 34, und dem wellenlängenselektiven optischen Reflexionselement 40 in Form eines planen Beugungsgitters als Resonatorendspiegel gebildet wird. Die Auskopplung des Laserlichts 15 kann - ebenso wie bei der Littman-Anordnung von Fig. 1 - über das Beugungsgitter 40 erfolgen (nicht dargestellt).

Um der Laserdioden-Anordnung 10 deutlich mehr Leistung entnehmen zu können, ist in Fig. 2 vorgesehen, daß die Laserstrahlung 15 über die Rückfacette 16 der Laserdiode 11 ausgekoppelt wird. Dabei ist das Verhältnis der Reflektivität der Rückfacette 16 zur Reflektivität des optischen Gitters 40 sehr viel kleiner als 1, vorzugsweise sehr viel kleiner als 0,1 ist. Konkret erreicht man dieses Verhältnis dadurch, daß die Reflektivität der Rückfacette 16 kleiner oder gleich 1 % und die Reflektivität des Gitters 40 größer oder gleich 95 % ist. Mithin wird von dem externen Resonator R2 sehr viel mehr Licht in die Laserdiode 11 zurückgekoppelt, die dadurch Laserlicht 13 mit einer sehr viel höheren Leistung emittiert.

Eine weitere Leistungssteigerung erzielt man, wenn die Laserdiode 11 in Axialrichtung A eine Länge D aufweist, die größer oder gleich 500 µm ist.

Für eine gezielte Nutzung des von der Laserdioden-Anordnung 10 emittierten Laserstrahlung 15 ist im Bereich der Rückfacette 16 eine optische Transmissionskomponente 70 angeordnet, z.B. eine Kollimationslinse 72.

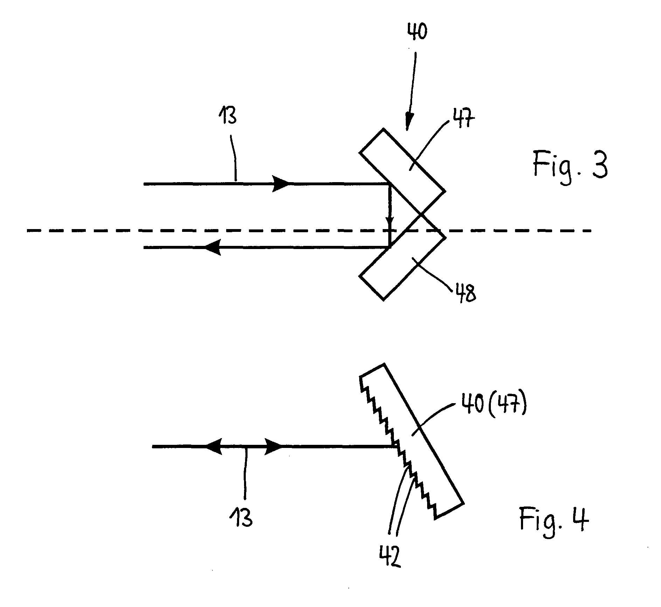

Die Ausführungsform von Fig. 3 zeigt eine andere Variante zur Realisierung der Justageinvarianz. Hierbei wird das plane Beugungsgitter 40 der Littrow-Anordnung von Fig. 2 ersetzt durch ein Hutgitter, das von zwei Teilgittern 47, 48 gebildet wird, die in einem Winkel von 90° zueinander angeordnet sind. Einfallendes kollimiertes monochromatisches Licht wird parallel versetzt und in die Richtung zurückreflektiert aus der es gekommen ist. Hierdurch wird der Laser 10 invariant gegenüber Verkippungen des Hutgitters 40 senkrecht zu den Gitterlinien 42, während das Abstimmverhalten beim Verschwenken des Gitters 40 um eine Achse parallel zu den Gitterlinien 42 erhalten bleibt.

Die Erfindung ist nicht auf eine der vorbeschriebenen Ausführungsformen beschränkt, sondern in vielfältiger Weise abwandelbar. So sieht die Ausführungsform von Fig. 1 vor, daß die bevorzugt rotationssymmetrische Sammellinse 32 zwischen der Laserdiode 11 und der Zylinderlinse 34 angeordnet ist. Es kann jedoch auch günstig sein, wenn man die Zylinderlinse 34 zwischen der Laserdiode 11 und der Sammellinse 32 anordnet. Um die Abbildung des Laserlichts 13 auf das Gitter 40 weiter zu verbessern, insbesondere um Abbildungsfehler zu vermeiden, ist es zweckmäßig, die Linse 32 als asphärische Linse auszubilden.

Die Laserdiode 11 hat bevorzugt eine aktive Zone mit einer rechteckigen Form. Um das Anschwingen von räumlichen Moden zu verhindern, kann man die aktive Zone trapezförmig ausbilden. Auch hierdurch erzielt man verbesserte Leistungswerte.

Eine noch andere Ausführungsform der Laserdioden-Anordnung 10 sieht vor, daß die Laserdiode 11 ein Quantenkaskadenlaser ist. Mit diesem lassen sich Wellenlängenbereiche von 4 µm bis 12 µm abdecken, was mit herkömmlichen Laserdioden nicht möglich ist. Die erfindungsgemäße Modifikation der Laserdiode 11 sorgt jedoch für eine stets modensprungfreie Durchstimmbarkeit. Alternativ kann man als Laserdiode 11 auch einen Quantenpunktlaser oder ein Dilute-Nitrid-Arsenid-Laser verwenden. Auch hierdurch können sich weitere anwendungsspezifische Vorteile ergeben.

Man erkennt, daß eine Laserdioden-Anordnung 10 zur Erzeugung von einmodiger, durchstimmbarer Laserstrahlung 15 eine Laserdiode 11 hat, die eine Rückfacette 16 und eine Frontfacette 17 aufweist und einen ersten Resonator R1 bildet. Ferner ist ein daran angekoppelter externer Resonator R2 vorgesehen, der wenigstens eine optische Transmissionskomponente 30 und wenigstens ein wellenlängenselektives optisches Reflexionselement 40, 50 aufweist und von der Laserdiode 11 emittiertes Laserlicht 13 in den ersten Resonator R1 zurückkoppelt. Um die Wellenlänge kontinuierlich und frei von Modensprüngen durchstimmen zu können und um gleichzeitig eine höhere Ausgangsleistung zu erreichen, ist eine Einrichtung 60 zur Variation der Ankopplungsgüte des ersten Resonators R1 an den externen Resonator R2 vorgesehen ist. Die Einrichtung 60 ist bevorzugt ein auf der Laserdiode 11 aufgebrachter elektrischer Anschlußkontakt 61, der in voneinander unabhängig ansteuerbare Anschlußsegmente 62, 63 unterteilt ist. Jedes Anschlußsegment 62, 63 ist über eine Regelschaltung 66 mit einem Steuerstrom beaufschlagbar, wobei der der dem ersten Anschlußsegment 62 zugeführte Steuerstrom konstant ist und der dem weiteren Anschlußsegment 63 zugeführte Steuerstrom in Abhängigkeit von der Position der wellenlängenselektiven optischen Reflexionselemente 40, 50 in Bezug zur Laserdiode 11 von der Regelschaltung 66 veränderbar ist.

Sämtliche aus den Ansprüchen, der Beschreibung und der Zeichnung hervorgehenden Merkmale und Vorteile, einschließlich konstruktiver Einzelheiten, räumlicher Anordnungen und Verfahrensschritten, können sowohl für sich als auch in den verschiedensten Kombinationen erfindungswesentlich sein.

### Bezugszeichenliste

- A: Längsachse (Laserdiode)
- D: Länge (Laserdiode)
- H: Hauptsegment
- I: Länge (Anschlußsegment)
- L: Länge (Anschlußsegment)
- R1: Resonator
- R2: externer Resonator
- S: Steuersegment
- Z: Linsenachse

- 10: Laserdioden-Anordnung
- 11: Laserdiode
- 12: Träger
- 13: Laserstrahlung
- 14: Laserstrahlung
- 15: Laserlicht / Nutzstrahl
- 16: Rückfacette
- 17: Frontfacette

- 30: optische Transmissionskomponente
- 32: Kollimator / asphärische Linse
- 34: Zylinderlinse

- 40: optisches Reflexionselement /Gitter
- 42: Gitterlinien
- 43: Drehachse
- 44: Träger
- 46: Justiermittel
- 47: Teilgitter
- 48: Teilgitter

- 50: Spiegel
- 52: Tragarm
- 54: Drehachse

- 60: Einrichtung zur Variation der Ankopplungsgüte
- 61: elektrische Anschlußkontakte
- 62: Anschlußsegment
- 63: Anschlußsegment
- 64: Anschlußleitung
- 65: Anschlußleitung
- 66: Steuerung/Regler

- 70: optische Transmissionskomponente
- 72: Kollimator / asphärische Linse

## Patentansprüche

1. Laserdioden-Anordnung (10) zur Erzeugung von einmodiger, durchstimmbarer Laserstrahlung (15), mit einer Laserdiode (11), die eine Rückfacette (16) und eine Frontfacette (17) aufweist und einen ersten Resonator (R1) bildet, und mit einem daran angekoppelten externen Resonator (R2), der wenigstens eine optische Transmissionskomponente (30) und wenigstens ein wellenlängenselektives optisches Reflexionselement (40, 50) aufweist und von der Laserdiode (11) emittiertes Laserlicht (13) in den ersten Resonator (R1) zurückkoppelt, **dadurch gekennzeichnet, daß** eine Einrichtung (60) zur Variation der Ankopplungsgüte des ersten Resonators (R1) an den externen Resonator (R2) vorgesehen ist.

2. Anordnung nach Anspruch 1, **dadurch gekennzeichnet, daß** die Einrichtung (60) zur Variation der Ankopplungsgüte an oder in dem ersten Resonator (R1) ausgebildet ist.

3. Anordnung nach Anspruch 1 oder 2, **dadurch gekennzeichnet, daß** die Einrichtung (60) zur Variation der Ankopplungsgüte an oder in der Laserdiode (11) ausgebildet ist.

4. Anordnung nach Anspruch 3, **dadurch gekennzeichnet, daß** die Einrichtung (60) zur Variation der Ankopplungsgüte einen auf der Laserdiode (11) aufgebrachten elektrischen Anschlußkontakt (61) umfaßt, der in voneinander unabhängig ansteuerbare Anschlußsegmente (62, 63) unterteilt ist.

5. Anordnung nach Anspruch 4, **dadurch gekennzeichnet, daß** der Anschlußkontakt (61) senkrecht zur Längsachse (A) der Laserdiode (11) unterteilt ist, wobei das der Rückfacette (16) zugewandte erste Anschlußsegment (62) eine Länge (L) aufweist, die größer ist als die Länge (I) des weiteren Anschlußsegments (63).

6. Anordnung nach Anspruch 4 oder 5, **dadurch gekennzeichnet, daß** jedes Anschlußsegment (62, 63) über eine Regelschaltung (66) mit einem Steuerstrom beaufschlagbar ist.

7. Anordnung nach einem der Ansprüche 4 bis 6, **dadurch gekennzeichnet, daß** der dem ersten Anschlußsegment (62) zugeführte Steuerstrom konstant ist.

8. Anordnung nach einem der Ansprüche 4 bis 7, **dadurch gekennzeichnet, daß** der dem weiteren Anschlußsegment (63) zugeführte Steuerstrom in Abhängigkeit von der Position der wellenlängenselektiven optischen Reflexionselemente (40, 50) in Bezug zur Laserdiode (11) von der Regelschaltung (66) veränderbar ist.

9. Anordnung nach Anspruch 8, **dadurch gekennzeichnet, daß** der dem weiteren Anschlußsegment (63) zugeführte Steuerstrom und die Position der bzw. des wellenlängenselektiven optischen Reflexionselements (40, 50) in einer über die Regelschaltung (66) vorgebbaren Beziehung zueinander stehen.

10. Anordnung nach einem der Ansprüche 4 bis 9, **dadurch gekennzeichnet, daß** der dem weiteren Anschlußsegment (63) zugeführte Steuerstrom in Abhängigkeit von der Leistung der aus der Laserdioden-Anordnung (10) ausgekoppelten Laserstrahlung (15) von der Regelschaltung (66) veränderbar ist.

11. Anordnung nach einem der Ansprüche 1 bis 10, **dadurch gekennzeichnet, daß** die Rückfacette (16) der Laserdiode (11) verspiegelt ist.

12. Anordnung nach einem der Ansprüche 1 bis 11, **dadurch gekennzeichnet, daß** die dem externen Resonator (R2) zugewandte Frontfacette (17) der Laserdiode (11) mit einer Antireflexionsbeschichtung versehen ist.

13. Anordnung nach Anspruch 12, **dadurch gekennzeichnet, daß** die Reflektivität der antireflexionsbeschichteten Frontfacette (17) kleiner als 0,001 beträgt.

14. Anordnung nach einem der Ansprüche 1 bis 13, **dadurch gekennzeichnet, daß** die Laserdiode (11) eine aktive Zone aufweist, die eine rechteckige oder trapezförmige Form hat.

15. Anordnung nach einem der Ansprüche 1 bis 14, **dadurch gekennzeichnet, daß** die optische Transmissionskomponente (30) einen Kollimator (32) aufweist.

16. Anordnung nach einem der Ansprüche 1 bis 15, **dadurch gekennzeichnet, daß** das wellenlängenselektive Reflexionselement (40) ein optisches Beugungsgitter ist.

17. Anordnung nach einem der Ansprüche 1 bis 16, **dadurch gekennzeichnet, daß** das wellenlängenselektive Reflexionselement (50) ein Spiegel ist.

18. Anordnung nach einem der Ansprüche 1 bis 17, **dadurch gekennzeichnet, daß** die Laserdiode (11) und der externe Resonator (R2) eine Littman- oder eine Littrow-Anordnung bilden.

19. Anordnung nach einem der Ansprüche 1 bis 18, **dadurch gekennzeichnet, daß** die Laserdiode (11) ein Quantenkaskadenlaser, ein Quantenpunktlaser oder ein Dilute-Nitrid-Arsenid-Laser ist.

20. Anordnung nach einem der Ansprüche 1 bis 19, **dadurch gekennzeichnet, daß** die Laserstrahlung (15) über die Rückfacette (16) der Laserdiode (11) auskoppelbar ist, wobei das Verhältnis der Reflektivität der Rückfacette (16) zur Reflektivität des optischen Reflexionselements (40) sehr viel kleiner als 1 ist.

21. Anordnung nach Anspruch 1, **dadurch gekennzeichnet, daß** das Verhältnis der Reflektivität der Rückfacette (16) zur Reflektivität des optischen Reflexionselements (40) kleiner als 0,1 ist.

22. Anordnung nach Anspruch 1 oder 2, **dadurch gekennzeichnet, daß** die Reflektivität der Rückfacette (16) kleiner oder gleich 0,01 und die Reflektivität des optischen Reflexionselements (40) größer oder gleich 0,95 ist.

23. Anordnung nach einem der Ansprüche 1 bis 3, **dadurch gekennzeichnet, daß** die Laserdiode (11) in Axialrichtung (A) eine Länge (D) aufweist, die größer oder gleich 500 µm ist.

24. Anordnung nach einem der Ansprüche 1 bis 4, **dadurch gekennzeichnet, daß** im Bereich der Rückfacette (16) eine optische Transmissionskomponente (70) angeordnet ist, z.B. eine Kollimationslinse (72).

25. Laserdioden-Anordnung (10) zur Erzeugung von einmodiger, durchstimmbarer Laserstrahlung (15), mit einer Laserdiode (11), die eine Rückfacette (16) und eine Frontfacette (17) aufweist und einen ersten Resonator (R1) bildet, und mit einem daran angekoppelten externen Resonator (R2), der wenigstens eine optische Transmissionskomponente (30) und wenigstens ein wellenlängenselektives optisches Reflexionselement (40, 50) aufweist und von der Laserdiode (11) emittiertes Laserlicht (13) in den ersten Resonator (R1) zurückkoppelt, insbesondere nach einem Ansprüche 1 bis 25, **dadurch gekennzeichnet, daß** der Transmissionskomponente (30) eine Sammellinse (32) und eine zerstreuende Zylinderlinse (34) zugeordnet ist, wobei die Achse (Z) der Zylinderlinse (34) im wesentlichen parallel zu den optischen Reflexionselementen (40, 50) angeordnet ist.

26. Anordnung nach Anspruch 25, **dadurch gekennzeichnet, daß** die Zylinderlinse (34) zwischen der Laserdiode (11) und der Sammellinse (32) angeordnet ist.

27. Anordnung nach Anspruch 25, **dadurch gekennzeichnet, daß** die Sammellinse (32) zwischen der Laserdiode (11) und der Zylinderlinse (34) angeordnet ist.

28. Anordnung nach wenigstens einem der Ansprüche 1 bis 27, **dadurch gekennzeichnet, daß** das optische Reflexionselement (40) von zwei Teilgittern (47, 48) gebildet wird, die in einem Winkel von 90° zueinander angeordnet sind.
